# EUROPEAN PATENT APPLICATION

(11) **EP 4 432 072 A1**
(43) Date of publication of application: **18.09.2024**
(21) Application number: 23210427.3
(22) Date of filing: 16.11.2023
(51) Int. Cl.: G06F 7/501, H03K 19/00

(54) **STATIC CMOS-BASED COMPACT FULL ADDER CIRCUITS**

(30) Priority: 16.03.2023 IN 202341017683
(71) Applicant: Samsung Electronics Co., Ltd., Suwon-si, Gyeonggi-do 16677 (KR)
(72) Inventor: ZOND, Saurabh Shankar, 560048 Bengaluru (IN); BANERJEE, Debojyoti, 560048 Bengaluru (IN); GHOSH, Abhishek, 560048 Bengaluru (IN); SHIRODKAR, Raghavendra, 560048 Bengaluru (IN); DIMRI, Rakesh, 560048 Bengaluru (IN); H G, Yashaswini, 560048 Bengaluru (IN)
(74) Representative: Marks & Clerk LLP

(57) **Abstract**

Provided is an apparatus that includes an integrated circuit including a static complementary metal-oxide-semiconductor based full adder (FA) circuit. The FA circuit comprises a sum generation circuit configured to generate a sum output and a carry output generation circuit configured to generate a carry output. The sum generation circuit comprises a first exclusive-NOR gate and a second exclusive-NOR gate. The carry output generation circuit comprises a first or- and-invert (OAI) gate, a second OAI gate, and a NAND gate. The first OAI gate is configured to receive an output of the NAND gate to generate one of an exclusive-NOR output or a NOR output of a first operand and a second operand. The second OAI gate is configured to receive the output of the NAND gate, an inverse of a carry input, and the generated one of the exclusive-NOR output or the NOR output to produce the carry output.

## Description

### FIELD

The present disclosure relates to high-performance digital integrated circuits associated with implementation of a static CMOS-based Full Adder.

### BACKGROUND

In recent developments in system on chips (SoCs), full adders may be computationally-heavy blocks of the SoC. The various units of the SoCs that consume power are logic implementation, full adders, flip flops, RAM, clock tree, and integrated clock gating (ICG) cells. The full adders may cover most of the total area of the SoCs and consume one-third of the total power in a typical digital design.

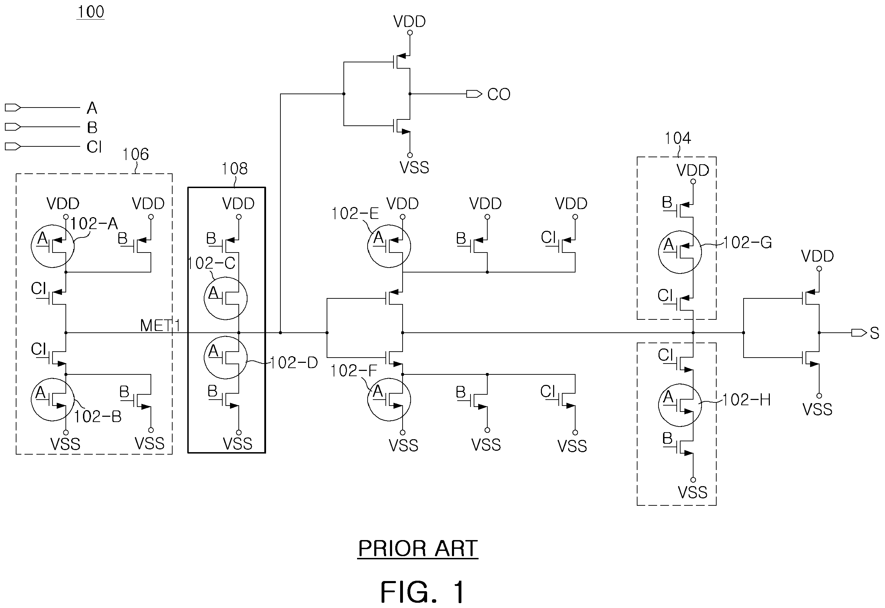

A complementary metal-oxide-semiconductor (CMOS) based mirror full adder is one of the broadly utilized economical implementations of the full adder in CMOS technology. However, a conventional CMOS-based mirror full adder may include 3 MOS stacking of PMOS and NMOS transistors in the sum generation path. As an example, FIG. 1 of the drawings illustrates a conventional CMOS-based mirror full adder circuit 100. In FIG. 1, a part of the circuitry highlighted by dashed lines 104 indicates 3 MOS stacking of PMOS and NMOS transistors in the sum generation path. Also, as shown in FIG. 1, MET1 is driven by at least 2 MOS stacks and drives 4 MOS gates. Therefore, this may degrade the delay in most of the sum and carry output arcs. Further, in the conventional CMOS-based mirror full adder as shown in FIG. 1, a carry propagation circuit 106 and a carry generation circuit 108 are combined to form the carry out generation section CO in a single stage. Furthermore, as shown in FIG. 1, each of A and B input pins are connected to 8 MOS transistors (e.g., transistors 102-A through 102-H each have input pin A connected thereto) and the CI input pin is connected to 6 MOS transistors. In general, the performance factor will be reduced in such a full adder where input pins A/B are connected to 8 MOS transistors and input pin Cl is connected to 6 MOS transistors.

Thus, there are 28 transistors used in creating this conventional full adder circuit, which is fairly high for any modern SoC employed for artificial intelligence (Al) / machine learning (ML) applications. In general, the performance factor will be reduced in such a full adder where input pins A/B are connected to 8 MOS transistors and input pin CI is connected to 6 MOS transistors. Accordingly, it may be advantageous to reduce the area of the full adder circuit which may help in area savings at block level which may be desirable. Further, it may be advantageous to reduce the number of transistors being used to implement the full adder circuit, which may lead to power savings at the block level.

### SUMMARY

This summary is provided to introduce a selection of inventive concepts in a simplified format that is further described in the detailed description of the inventive concepts. This summary is not intended to identify key or essential inventive concepts, nor is it intended for determining the scope of the inventive concepts.

According to one or more example embodiments, a Full Adder (FA) circuit is disclosed. The FA circuit comprises a sum generation circuit configured to generate a sum output (S) and a carry output generation circuit configured to generate a carry output (CO). Each of the sum generation circuit and the carry output generation circuit is configured to receive a first operand input (A), a second operand input (B), and a carry input (CI), wherein the sum generation circuit comprises a first exclusive-NOR gate and a second exclusive-NOR gate, wherein the second exclusive-NOR gate is configured to receive an output of the first exclusive-NOR gate to produce the sum output (S). The carry output generation circuit comprises a first or-and-invert (OAI) gate, a second or-and-invert (OAI) gate, and a NAND gate. The first OAI gate is configured to receive an output of the NAND gate to generate one of an exclusive-NOR output or a NOR output of the first operand (A) and the second operand (B). The second OAI gate is configured to receive the output of the NAND gate, an inverse of the carry input, and the generated one of the exclusive-NOR output or the NOR output to produce the carry output (CO).

According to one or more other example embodiments, a Full Adder (FA) circuit is disclosed. The FA circuit comprises a sum generation circuit configured to generate a sum output and a carry output generation circuit configured to generate a carry output. Each of the sum generation circuit and the carry output generation circuit is configured to receive a first operand input, a second operand input, and a carry input. The sum generation circuit comprises a first exclusive-OR gate and a second exclusive-OR gate, wherein the second exclusive-OR gate is configured to receive an output of the first exclusive-OR gate to produce the sum output. The carry output generation circuit comprises a first and-or-invert (AOI) gate, a second and-or-invert (AOI) gate, and a NOR gate. The carry output generation circuit is configured such that one of: the first AOI gate is configured to receive an output of the NOR gate to generate one of an exclusive-OR output or a NAND output of the first operand and the second operand, and the second AOI gate is configured to receive the output of the NOR gate, an inverse of the carry input, and the generated one of the exclusive-OR output or the NAND output to produce the carry output.

To further clarify the advantages and features of the present inventive concepts, a more particular description of the inventive concepts will be rendered by reference to specific example embodiments thereof, which are illustrated in the appended drawings. It is appreciated that these drawings depict only example embodiments of the inventive concepts and are therefore not to be considered limiting of its scope. The inventive concepts will be described and explained with additional specificity and detail with the accompanying drawings.

At least some of the above and other features of the invention are set out in the claims.

### BRIEF DESCRIPTION OF THE DRAWINGS

These and other features, aspects, and advantages of the present inventive concepts will become better understood when the following detailed description is read with reference to the accompanying drawings in which like characters represent like elements throughout the drawings, wherein:
FIG. 1 illustrates a conventional CMOS-based mirror full adder circuit, in accordance with conventional state of the art;
FIGS. 2-5 illustrate circuit architectures of CMOS-based full adder topologies, in accordance with some example embodiments of the present disclosure; and
FIG. 6 illustrates a computing system, in accordance with some example embodiments of the present inventive concepts.

Further, skilled artisans will appreciate that elements in the drawings are illustrated for simplicity and may not have necessarily been drawn to scale. Furthermore, in terms of the construction of the device, one or more components of the device may have been represented in the drawings by conventional symbols, and the drawings may show only those specific details that are pertinent to understanding example embodiments of the present inventive concepts so as not to obscure the drawings with details that will be readily apparent to those of ordinary skill in the art having the benefit of the description herein.

### DETAILED DESCRIPTION

It should be understood at the outset that although illustrative implementations of example embodiments of the present disclosure are illustrated below, the present inventive concepts may be implemented using any number of techniques, whether currently known or in existence. The present disclosure should in no way be limited to the illustrative implementations, drawings, and techniques illustrated below, including the example designs and implementations illustrated and described herein, but may be modified within the scope of the appended claims along with their full scope of equivalents.

The term "some" as used herein is defined as "one, or more than one, or all." Accordingly, the terms "one," "more than one," "more than one, but not all" or "all" would all fall under the definition of "some." The term "some example embodiments" may refer to one example embodiment or to several example embodiments or to all example embodiments. Accordingly, the term "some example embodiments" is defined as meaning "one example embodiment, or more than one example embodiment, or all example embodiments."

The terminology and structure employed herein are for describing, teaching, and illuminating example embodiments and their specific features and elements and do not restrict, or reduce the scope of the claims or their equivalents.

Moreover, any terms used herein such as but not limited to "includes," "comprises," "has," "consists," and grammatical variants thereof do not specify an exact limitation or restriction and certainly do not exclude the possible addition of one or more features or elements, unless otherwise stated, and furthermore must not be taken to exclude the possible removal of one or more of the listed features and elements, unless otherwise stated with the limiting language "must comprise" or "needs to include."

Whether or not a certain feature or element was described in singular form, it may still be referred to as "one or more features" or "one or more elements" or "at least one feature" or "at least one element." Furthermore, the use of the terms "one or more" or "at least one" feature or element does not preclude there being none of that feature or element unless otherwise specified by limiting language such as "there needs to be one or more ... " or "one or more element is required."

Unless otherwise defined, all terms, and especially any technical and/or scientific terms, used herein may be taken to have the same meaning as commonly understood by one having ordinary skill in the art.

Example embodiments of the present inventive concepts will be described below in detail with reference to the accompanying drawings.

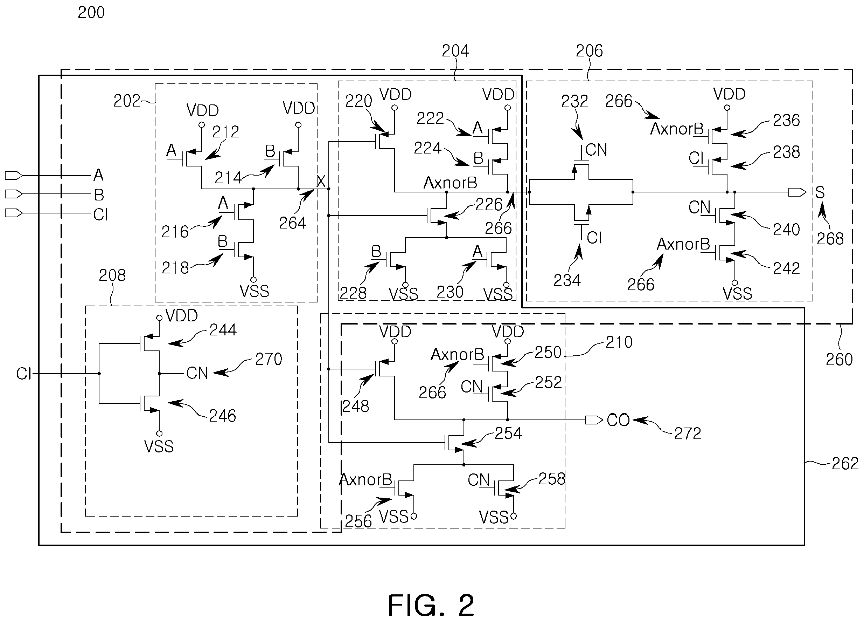

FIG. 2 illustrates a circuit architecture of CMOS-based full adder topology, in accordance with some example embodiments of the present disclosure. FIG. 2 depicts an integrated circuit 200 including a static complementary metal-oxide-semiconductor (CMOS) based Full Adder (FA) circuit. The static CMOS-based FA circuit includes a sum generation circuit 260 and/or a carry output generation circuit 262. The aforementioned circuit components of the integrated circuit 200 are coupled with each other. The detailed interconnection and working of each of the circuit components will be explained in the forthcoming paragraphs. Further, the reference numerals are kept the same wherever applicable for the sake of simplicity and ease of explanation.

In some example embodiments, the sum generation circuit 260 comprises a plurality of Boolean logic circuits including 202, 204, 206, and/or 208. The sum generation circuit 260 is configured to receive one or more first operand inputs (A), one or more second operand inputs (B), one or more carry inputs (CI), and one or more inverse of carry (CN).

The circuit 202 comprises a NAND logic circuit (circuit with output Node X) configured to receive the first operand input A at the gate terminal of PMOS transistor 212 and the gate terminal of NMOS transistor 216. Further, the NAND logic circuit is configured to receive the second operand input B at the gate terminal of PMOS transistor 214 and the gate terminal of NMOS transistor 218. A source terminal of each of the PMOS transistors 212 and 214 is coupled to a power terminal VDD. Further, a source terminal of the NMOS transistor 218 is coupled to VSS (e.g., ground terminal). The drain terminal of each of the PMOS transistors 212, 214 and the source terminal of the NMOS transistor 216 are coupled to the output node X 264. Further, the drain terminal of NMOS transistor 216 and the drain terminal of the NMOS transistor 218 are coupled to each other. The output of the circuit 202 is X or A NAND B 264 (e.g., (A.B)').

The circuit 204 comprises a Boolean logic circuit associated with an OR-AND-INVERT (OAI) gate. The circuit 204 is configured to receive the first operand input A at the gate terminal of PMOS transistor 222 and the gate terminal of NMOS transistor 230. Further, the circuit 204 is configured to receive the second operand input B at the gate terminal of PMOS transistor 224 and the gate terminal of NMOS transistor 228. Further, the circuit 204 is configured to receive the output X 264 of the circuit 202 as an input at the gate terminals of PMOS transistor 220 and NMOS transistor 226. A source terminal of each of the PMOS transistors 220 and 222 is coupled to a power terminal VDD. Further, a source terminal of the NMOS transistors 228 and 230 is coupled to VSS (e.g., ground terminal). The drain terminal of each of the PMOS transistors 220, 224 and the NMOS transistor 226 are coupled to the output node 266. Further, the drain terminal of PMOS transistor 222 and the source terminal of the PMOS transistor 224 are coupled to each other. The drain terminals of NMOS transistors 228, 230 and the source terminal of NMOS transistor 226 are coupled to each other. The output of the circuit 204 is A XNOR B 266.

The circuit 208 comprises a Boolean logic circuit for generating a negative carry output (CN) 270 for an input carry (CI). For example, the circuit 208 comprises a PMOS transistor 244 and an NMOS transistor 246. The gates of each of the PMOS transistor 244 and the NMOS transistor 246 are configured to receive the carry input (CI). A source terminal of the PMOS transistor 244 is coupled to a power terminal VDD. Further, a source terminal of the NMOS transistor 246 is coupled to VSS (e.g., ground terminal). The drain terminal of each of the PMOS transistor 244 and the NMOS transistor 246 are coupled to the output node 270, e.g., negative carry CN.

The circuit 206 comprises a Boolean logic circuit associated with an exclusive-NOR gate. The circuit 206 comprises a bypass circuit including transistors 232 and 234, and a stack of transistors comprising transistors 236, 238, 240, and 242. The circuit 206 is configured to receive the carry input (CI) at the gate terminal of PMOS transistor 238 and at the gate terminal of NMOS transistor 234. Further, the circuit 206 is configured to receive the inverse of carry (CN) as an input at the gate terminal of PMOS transistor 232 and at the gate terminal of NMOS transistor 240. Further, the circuit 206 is configured to receive the output A XNOR B 266 of the circuit 204 as an input at the gate terminals of PMOS transistor 236 and NMOS transistor 242. The output of the circuit 206 is the sum output 268, e.g., A XOR B XOR Cl. A source terminal of the PMOS transistor 236 is coupled to a power terminal VDD. Further, a source terminal of the NMOS transistor 242 is coupled to VSS (e.g., ground terminal). The drain terminal of each of the PMOS transistor 236 is coupled to the source terminal of the PMOS transistor 238. Further, the drain terminal of the NMOS transistor 242 is coupled to the source terminal of NMOS transistor 240. Furthermore, the drain terminal of the PMOS transistor 238 and the drain terminal of the NMOS transistor 240 are coupled to the output of the bypass circuit comprising transistors 232 and 234 and the output sum generation S 268. Also, the source terminal of transistor 232 and the drain terminal of NMOS transistor 234 are coupled to output 266 of the circuit 204, while the drain terminal of PMOS transistor 232 and the source terminal of NMOS transistor 234 are coupled to each other as well as with the output node of S 268. Thus, the output sum generation 268 is produced based on circuits 202, 204, and 206.

In some example embodiments, the carry output generation circuit 262 comprises a plurality of Boolean logic circuits including 202, 204, 208, and/or 210. The carry output generation circuit 262 is configured to receive one or more first operand inputs (A), one or more second operand inputs (B), one or more carry inputs (CI), and one or more inverse of carry (CN) inputs. The circuits 202, 204, and 208 are common with the sum generation circuit 260.

The circuit 210 comprises a Boolean logic circuit associated with an OR-AND-INVERT gate. The circuit 210 is configured to receive the inverse of carry (CN) as an input at the gate terminal of PMOS transistor 252 and at the gate terminal of NMOS transistor 258. Further, the circuit 210 is configured to receive the output A XNOR B 266 of the circuit 204 as an input at the gate terminals of PMOS transistor 250 and NMOS transistor 256. Furthermore, the circuit 210 is configured to receive the output A NAND B 264 of the circuit 202 as an input at the gate terminals of PMOS transistor 248 and NMOS transistor 254. A source terminal of each of the PMOS transistors 248 and 250 is coupled to a power terminal VDD. Further, a source terminal of the NMOS transistors 256 and 258 is coupled to VSS (e.g., ground terminal). The drain terminal of each of the PMOS transistors 248, 252 and the NMOS transistor 254 are coupled to output node 272, e.g., carry output (CO). Further, the drain terminal of NMOS transistors 256, 258 and the source terminal of the NMOS transistor 254 are coupled to each other. The drain terminal of PMOS transistor 250 and the source terminal of PMOS transistor 252 are coupled to each other. The output of the circuit 210 is the carry output (CO) 272. Thus, the generation of the carry output (CO) 272 is produced based on circuits 202, 204, 208, and/or 210.

According to some example embodiments of the present disclosure, as shown in FIG. 2, the integrated circuit topology 200 is structured in order to limit a maximum number of NMOS and/or PMOS transistors, whereas the conventional full adder circuit as described in FIG. 1 has a 3-transistor stack. In particular, the number of stages and fan-out of the internal nodes of the circuit have been improved and/or optimized and hence help in reducing the overall delay of the circuit.

Also, the input pins A and B of the integrated circuitry topology 200 are each connected to no more than (e.g., exactly/only) 4 MOS transistors and input pin CI is connected to no more than (e.g., exactly/only) 4 MOS transistors, whereas the input pins A and B of the conventional full adder circuit as described in FIG. 1 are connected to 8 MOS transistors and the input pin CI of the conventional full adder circuit is connected to 6 MOS transistors. Further, the input pin CN is connected to no more than (e.g., exactly/only) 4 MOS transistors. Therefore, the integrated circuit topology 200 of the present inventive concepts helps in the reduction of the input capacitance for a preceding stage of the circuit. Moreover, the integrated circuit topology 200 of the present inventive concept helps reduce the size (e.g., total area) of the full adder circuit. The maximum number of MOS transistors in the circuit topology is 24 compared to 28 MOS transistors in FIG. 1 of the background.

According to some example embodiments of the present disclosure, the integrated circuitry topology 200 design is robust in lower voltage and is free of static 1 or static 0 hazards, thereby enhancing the performance of the CMOS circuitry.

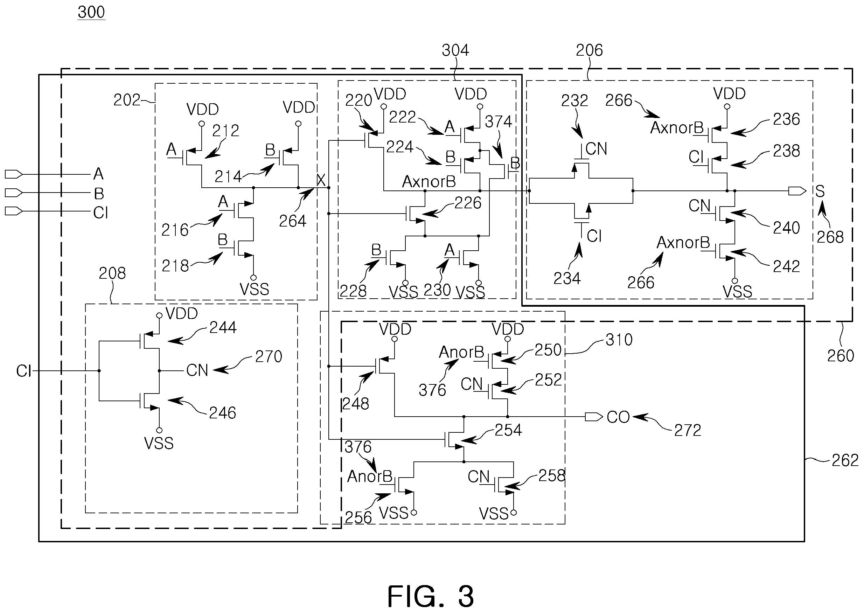

FIG. 3 illustrates another circuit architecture of CMOS-based full adder topology, in accordance with some example embodiments of the present disclosure. FIG. 3 depicts an integrated circuit 300 including a static complementary metal-oxide-semiconductor (CMOS) based Full Adder (FA) circuit. The static CMOS-based FA circuit includes a sum generation circuit 260 and/or a carry output generation circuit 262. The aforementioned circuit components of the integrated circuit 300 are coupled with each other. The detailed interconnection and working of each of the circuit components will be explained in the forthcoming paragraphs. Further, the reference numerals are kept the same wherever applicable for the sake of simplicity and ease of explanation.

In some example embodiments, the sum generation circuit 260 comprises a plurality of Boolean logic circuits including 202, 304, 206, and/or 208. The sum generation circuit 260 is configured to receive one or more first operand inputs (A), one or more second operand inputs (B), one or more carry inputs (CI), and one or more inverse of carry (CN) or negative carry (CN).

The circuit 202 comprises a NAND logic circuit (circuit with output Node X) configured to receive the first operand input A at the gate terminal of PMOS transistor 212 and the gate terminal of NMOS transistor 216. Further, the NAND logic circuit is configured to receive the second operand input B at the gate terminal of the PMOS transistor 214 and the gate terminal of the NMOS transistor 218. A source terminal of each of the PMOS transistors 212 and 214 is coupled to a power terminal VDD. Further, a source terminal of the NMOS transistor 218 is coupled to VSS (e.g., ground terminal). The drain terminal of each of the PMOS transistors 212, 214 and the source terminal of the NMOS transistor 216 are coupled to the output node X 264. Further, the drain terminal of NMOS transistor 216 and the drain terminal of the NMOS transistor 218 are coupled to each other. The output of the circuit 202 is X or A NAND B 264 (e.g., (A.B)').

The circuit 304 comprises a Boolean logic circuit associated with an OR-AND-INVERT (OAI) gate. The circuit 304 is configured to receive the first operand input A at the gate terminal of PMOS transistor 222 and the gate terminal of NMOS transistor 230. Further, the circuit 304 is configured to receive the second operand input B at the gate terminal of PMOS transistor 224 and the gate terminal of NMOS transistor 228. Further, the circuit 304 is configured to receive the output X 264 of the circuit 202 as an input at the gate terminals of PMOS transistor 220 and NMOS transistor 226. A source terminal of each of the PMOS transistors 220 and 222 is coupled to a power terminal VDD. Further, a source terminal of the NMOS transistors 228 and 230 is coupled to VSS (e.g., ground terminal). The drain terminal of each of the PMOS transistors 220, 224 and the NMOS transistor 226 are coupled to the output node 266. Further, the drain terminal of PMOS transistor 222 and the source terminal of the PMOS transistor 224 are coupled to each other. Further, the drain terminal of PMOS transistor 222 and the source terminal of the PMOS transistor 224 are coupled to the source terminal of PMOS transistor 374. The PMOS transistor 374 is configured to receive operand B at the gate terminal. The drain terminals of NMOS transistors 228, 230, the source terminal of NMOS transistor 226, and the drain terminal of the PMOS transistor 374 are coupled to each other to provide the output A NOR B 376. The output of the circuit 304 is A XNOR B 266 and A NOR B 376.

The circuit 208 comprises a Boolean logic circuit for generating a negative carry output (CN) 270 for an input carry (CI). For example, the circuit 208 comprises a PMOS transistor 244 and an NMOS transistor 246. The gates of each of the PMOS transistor 244 and the NMOS transistor 246 are configured to receive the carry input (CI). A source terminal of the PMOS transistor 244 is coupled to a power terminal VDD. Further, a source terminal of the NMOS transistor 246 is coupled to VSS (e.g., ground terminal). The drain terminal of each of the PMOS transistor 244 and the NMOS transistor 246 are coupled to the output node 270, e.g., negative carry CN.

The circuit 206 comprises a Boolean logic circuit associated with an exclusive-NOR gate. The circuit 206 comprises a bypass circuit including transistors 232 and 234, and a stack of transistors comprising transistors 236, 238, 240, and 242. The circuit 206 is configured to receive the carry input (CI) at the gate terminal of PMOS transistor 238 and at the gate terminal of NMOS transistor 234. Further, the circuit 206 is configured to receive the inverse of carry (CN) as an input at the gate terminal of PMOS transistor 232 and at the gate terminal of NMOS transistor 240. Further, the circuit 206 is configured to receive the output A XNOR B 266 of the circuit 304 as an input at the gate terminals of PMOS transistor 236 and NMOS transistor 242. The output of the circuit 206 is the sum output 268, e.g., A XOR B XOR Cl. A source terminal of the PMOS transistor 236 is coupled to a power terminal VDD. Further, a source terminal of the NMOS transistor 242 is coupled to VSS (e.g., ground terminal). The drain terminal of each of the PMOS transistor 236 is coupled to the source terminal of the PMOS transistor 238. Further, the drain terminal of the NMOS transistor 242 is coupled to the source terminal of NMOS transistor 240. Furthermore, the drain terminal of the PMOS transistor 238 and the drain terminal of the NMOS transistor 240 are coupled to the output of the bypass circuit comprising transistors 232 and 234 and the output sum generation S 268. Also, the source terminal of transistor 232 and the drain terminal of NMOS transistor 234 are coupled to output 266 of the circuit 304, while the drain terminal of PMOS transistor 232 and the source terminal of NMOS transistor 234 are coupled to each other as well as with the output node of S 268. Thus, the output sum generation 268 is produced based on circuits 202, 204, and 206.

In some example embodiments, the carry output generation circuit 262 comprises a plurality of Boolean logic circuits including 202, 304, 208, and/or 310. The carry output generation circuit 262 is configured to receive one or more first operand inputs (A), one or more second operand inputs (B), one or more carry inputs (CI), and one or more inverse of carry (CN) inputs. The circuits 202, 304, and 208 are common with the sum generation circuit 260.

The circuit 310 comprises a Boolean logic circuit associated with an OR-AND-INVERT gate. The circuit 310 is configured to receive the inverse of carry (CN) as an input at the gate terminal of PMOS transistor 252 and at the gate terminal of NMOS transistor 258. Further, the circuit 310 is configured to receive the output A NOR B 376 of the circuit 304 as an input at the gate terminals of PMOS transistor 250 and NMOS transistor 256. Furthermore, the circuit 310 is configured to receive the output A NAND B 264 of the circuit 202 as an input at the gate terminals of PMOS transistor 248 and NMOS transistor 254. A source terminal of each of the PMOS transistors 248 and 250 is coupled to a power terminal VDD. Further, a source terminal of the NMOS transistors 256 and 258 is coupled to VSS (e.g., ground terminal). The drain terminal of each of the PMOS transistors 248, 252 and the NMOS transistor 254 are coupled to provide the output 272, e.g., carry output (CO). Further, the drain terminal of NMOS transistors 256, 258 and the source terminal of the NMOS transistor 254 are coupled to each other. The drain terminal of PMOS transistor 250 and the source terminal of PMOS transistor 252 are coupled to each other. The output of the circuit 310 is the carry output (CO) 272. Thus, the generation of the carry output (CO) 272 is produced based on circuits 202, 304, 208, and/or 310.

According to some example embodiments of the present disclosure, as shown in FIG. 3, the integrated circuit topology 300 is structured in order to limit a maximum number of NMOS and/or PMOS transistors, whereas the conventional full adder circuit as described in FIG. 1 has a 3-transistor stack. In particular, the number of stages and fan-out of the internal nodes of the circuit have been improved and/or optimized and hence help in reducing the overall delay of the circuit.

Also, the input pins A and B of the integrated circuitry topology 300 are each connected to no more than (e.g., exactly/only) 4 and 5 MOS transistors respectively, and input pin CI is connected to no more than (e.g., exactly/only) 4 MOS transistors, whereas the input pins A and B of the conventional full adder circuit as described in FIG. 1 are connected to 8 MOS transistors and the input pin CI of the conventional full adder circuit is connected to 6 MOS transistors. Further, the input pin CN is connected to no more than (e.g., exactly/only) 4 MOS transistors. Therefore, the integrated circuit topology 300 of the present inventive concepts helps in the reduction of the input capacitance for a preceding stage of the circuit. Moreover, the integrated circuit topology 200 of the present inventive concepts helps reduce the size (e.g., total area) of the full adder circuit. The maximum number of MOS transistors in the circuit topology is 25 compared to 28 MOS transistors in FIG. 1 of the background.

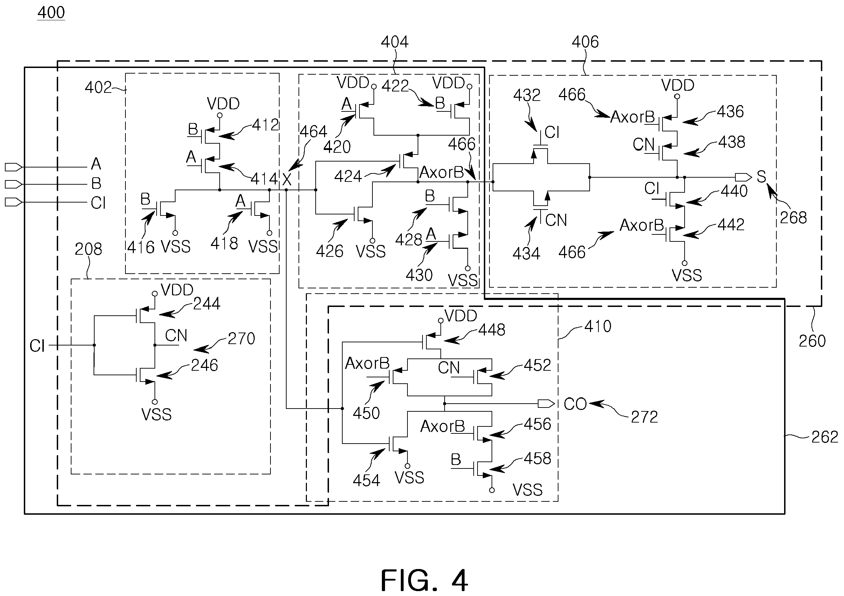

FIG. 4 illustrates another circuit architecture of CMOS-based full adder topology, in accordance with some example embodiments of the present disclosure. FIG. 4 depicts an integrated circuit 400 including a static complementary metal-oxide-semiconductor (CMOS) based Full Adder (FA) circuit. The static CMOS-based FA circuit includes a sum generation circuit 260 and/or a carry output generation circuit 262. The aforementioned circuit components of the integrated circuit 400 are coupled with each other. The detailed interconnection and working of each of the circuit components will be explained in the forthcoming paragraphs. Further, the reference numerals are kept the same wherever applicable for the sake of simplicity and ease of explanation.

In some example embodiments, the sum generation circuit 260 comprises a plurality of Boolean logic circuits including 402, 404, 406, and/or 208. The sum generation circuit 260 is configured to receive one or more first operand inputs (A), one or more second operand inputs (B), one or more carry inputs (CI), and one or more inverse of carry (CN) or inverse carry (CN).

The circuit 402 comprises a NOR logic circuit (circuit with output Node X) configured to receive the first operand input A at the gate terminal of PMOS transistor 414 and the gate terminal of NMOS transistor418. Further, the NOR logic circuit is configured to receive the second operand input B at the gate terminal of the PMOS transistor 412 and the gate terminal of the NMOS transistor 416. A source terminal of the PMOS transistor 412 is coupled to a power terminal VDD. Further, a source terminal of each of the NMOS transistors 416 and 418 is coupled to VSS (e.g., ground terminal). The drain terminal of each of the PMOS transistor 414 and the NMOS transistors 416 and 418 are coupled to provide the output X 464. Further, the source terminal of PMOS transistor 414 and the drain terminal of the PMOS transistor 412 are coupled to each other. The output of the circuit 402 is X or A NOR B 464 (e.g., (A+B)').

The circuit 404 comprises a Boolean logic circuit associated with an AND-OR-INVERT (AOI) gate. The circuit 404 is configured to receive the first operand input A at the gate terminal of PMOS transistor 420 and the gate terminal of NMOS transistor 430. Further, the circuit 404 is configured to receive the second operand input B at the gate terminal of PMOS transistor 422 and the gate terminal of NMOS transistor 428. Further, the circuit 204 is configured to receive the output X 464 of the circuit 402 as an input at the gate terminals of PMOS transistor 424 and NMOS transistor 426. A source terminal of each of the PMOS transistors 420 and 422 is coupled to a power terminal VDD. Further, a source terminal of the NMOS transistor 426 and a drain terminal of the NMOS transistor 430 is coupled to VSS (e.g., ground terminal). The drain terminal of each of the PMOS transistors 420, 422 and the source terminal of PMOS transistor 424 are coupled to each other. Further, the drain terminal of PMOS transistor 424 and the drain terminals of the NMOS transistors 426 and 428 are coupled to provide output 466, e.g., A XOR B. The source terminal of NMOS transistor 428 and the source terminal of NMOS transistor 430 are coupled to each other. The output of the circuit 404 is A XOR B 466.

The circuit 208 comprises a Boolean logic circuit for generating a negative carry output (CN) 270 for an input carry (CI). For example, the circuit 208 comprises a PMOS transistor 244 and an NMOS transistor 246. The gates of each of the PMOS transistor 244 and the NMOS transistor 246 are configured to receive the carry input (CI). A source terminal of the PMOS transistor 244 is coupled to a power terminal VDD. Further, a source terminal of the NMOS transistor 246 is coupled to VSS (e.g., ground terminal). The drain terminal of each of the PMOS transistor 244 and the NMOS transistor 246 are coupled to the output node 270, e.g., negative carry CN.

The circuit 406 comprises a Boolean logic circuit associated with an exclusive-OR gate. The circuit 406 comprises a bypass circuit including transistors 432 and 434, and a stack of transistors comprising transistors 436, 438, 440, and 442. The circuit 406 is configured to receive the negative carry input (CN) at the gate terminal of PMOS transistor 438 and at the gate terminal of NMOS transistor 434. Further, the circuit 406 is configured to receive the inverse of carry (CI) as an input at the gate terminal of PMOS transistor 432 and at the gate terminal of NMOS transistor 440. Further, the circuit 406 is configured to receive the output A XOR B 466 of the circuit 404 as an input at the gate terminals of PMOS transistor 436 and NMOS transistor 442. The output of the circuit 406 is the sum output 268, e.g., A XOR B XOR Cl. A source terminal of the PMOS transistor 436 is coupled to a power terminal VDD. Further, a drain terminal of the NMOS transistor 442 is coupled to VSS (e.g., ground terminal). The drain terminal of the PMOS transistor 436 is coupled to the source terminal of the PMOS transistor 438. Further, the source terminal of the NMOS transistor 442 is coupled to the source terminal of NMOS transistor 440. Furthermore, the drain terminal of the PMOS transistor 438 and the drain terminal of the NMOS transistor 440 are coupled to the output of the bypass circuit comprising transistors 432 and 434 and the output sum generation S 268. Also, the source terminal of transistor 432 and the drain terminal of NMOS transistor 434 are coupled to output 466 (A XOR B) of the circuit 404, while the drain terminal of PMOS transistor 432 and the source terminal of NMOS transistor 434 are coupled to each other as well as with the output node of S 268. Thus, the output sum generation 268 is produced based on circuits 402, 404, and 406.

In some example embodiments, the carry output generation circuit 262 comprises a plurality of Boolean logic circuits including 402, 404, 208, and/or 410. The carry output generation circuit 262 is configured to receive one or more first operand inputs (A), one or more second operand inputs (B), one or more carry inputs (CI), and one or more inverse of carry (CN) inputs. The circuits 402, 404, and 208 are common with the sum generation circuit 260.

The circuit 410 comprises a Boolean logic circuit associated with an AND-OR-INVERT gate. The circuit 410 is configured to receive the inverse of carry (CN) as an input at the gate terminal of PMOS transistor 452. Further, the circuit 410 is configured to receive the output A XOR B 466 of the circuit 404 as an input at the gate terminals of PMOS transistor 450 and NMOS transistor 456. Furthermore, the circuit 410 is configured to receive the output A NOR B 464 of the circuit 402 as an input at the gate terminals of PMOS transistor 448 and NMOS transistor 454. Further, the circuit 410 is configured to receive the operand B as an input at the gate terminal of NMOS transistor 458. A source terminal of the PMOS transistor 448 is coupled to a power terminal VDD. Further, a source terminal of each of the NMOS transistors 454 and 458 is coupled to VSS (e.g., ground terminal). The drain terminal of each of the PMOS transistors 450, 452 and the drain terminal of each of the NMOS transistors 454, 456 are coupled to provide the output 272, e.g., carry output (CO). The drain terminal of PMOS transistor 448 is coupled to the source terminal of the PMOS transistors 450 and 452. Further, the drain terminal of NMOS transistor 458 and the source terminal of the NMOS transistor 456 are coupled to each other. The output of the circuit 410 is the carry output (CO) 272. Thus, the generation of the carry output (CO) 272 is produced based on circuits 402, 404, 208, and/or 410.

According to some example embodiments of the present disclosure, as shown in FIG. 4, the integrated circuit topology 400 is structured in order to limit a maximum number of NMOS and/or PMOS transistors, whereas the conventional full adder circuit as described in FIG. 1 has a 3-transistor stack. In particular, the number of stages and fan-out of the internal nodes of the circuit have been improved and/or optimized and hence help in reducing the overall delay of the circuit.

Also, the input pins A and B of the integrated circuitry topology 400 are each connected to no more than (e.g., exactly/only) 4 and 5 MOS transistors respectively, and input pin CI is connected to no more than (e.g., exactly/only) 4 MOS transistors, whereas the input pins A and B of the conventional full adder circuit as described in FIG. 1 are connected to 8 MOS transistors and the input pin CI of the conventional full adder circuit is connected to 6 MOS transistors. Further, the input pin CN is connected to no more than (e.g., exactly/only) 3 MOS transistors. Therefore, the integrated circuit topology 400 of the present inventive concepts helps in the reduction of the input capacitance for a preceding stage of the circuit. Moreover, the integrated circuit topology 400 of the present inventive concepts helps reduce the size (e.g., total area) of the full adder circuit. The maximum number of MOS transistors in the circuit topology is 24 compared to 28 MOS transistors in FIG. 1 of the background.

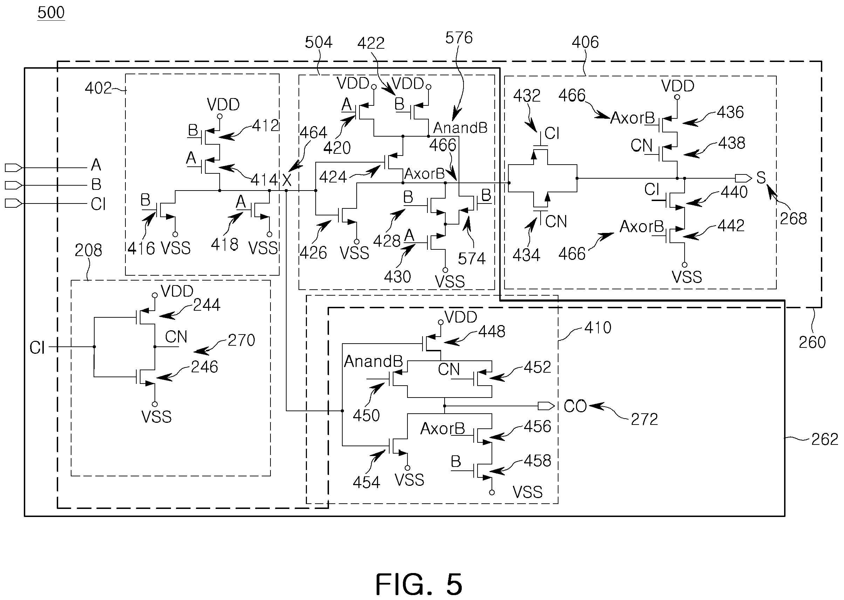

FIG. 5 illustrates another circuit architecture of CMOS-based full adder topology, in accordance with some example embodiments of the present disclosure. FIG. 5 depicts an integrated circuit 500 including a static complementary metal-oxide-semiconductor (CMOS) based Full Adder (FA) circuit. The static CMOS-based FA circuit includes a sum generation circuit 260 and/or a carry output generation circuit 262. The aforementioned circuit components of the integrated circuit 500 are coupled with each other. The detailed interconnection and working of each of the circuit components will be explained in the forthcoming paragraphs. Further, the reference numerals are kept the same wherever applicable for the sake of simplicity and ease of explanation.

In some example embodiments, the sum generation circuit 260 comprises a plurality of Boolean logic circuits including 402, 504, 406, and/or 208. The sum generation circuit 260 is configured to receive one or more first operand inputs (A), one or more second operand inputs (B), one or more carry inputs (CI), and one or more inverse of carry (CN) or negative carry (CN).

The circuit 402 comprises a NOR logic circuit (circuit with output Node X) configured to receive the first operand input A at the gate terminal of PMOS transistor 414 and the gate terminal of NMOS transistor418. Further, the NOR logic circuit is configured to receive the second operand input B at the gate terminal of the PMOS transistor 412 and the gate terminal of the NMOS transistor 416. A source terminal of the PMOS transistor 412 is coupled to a power terminal VDD. Further, a source terminal of each of the NMOS transistors 416 and 418 is coupled to VSS (e.g., ground terminal). The drain terminal of each of the PMOS transistor 414 and the NMOS transistors 416 and 418 are coupled to provide the output X 464. Further, the source terminal of PMOS transistor 414 and the drain terminal of the PMOS transistor 412 are coupled to each other. The output of the circuit 402 is X or A NOR B 464 (e.g., (A+B)').

The circuit 504 comprises a Boolean logic circuit associated with an AND-OR-INVERT (AOI) gate. The circuit 504 is configured to receive the first operand input A at the gate terminal of PMOS transistor 420 and the gate terminal of NMOS transistor 430. Further, the circuit 504 is configured to receive the second operand input B at the gate terminal of PMOS transistor 422 and the gate terminal of NMOS transistor 428. Further, the circuit 504 is configured to receive the output X 464 of the circuit 402 as an input at the gate terminals of PMOS transistor 424 and NMOS transistor 426. A source terminal of each of the PMOS transistors 420 and 422 is coupled to a power terminal VDD. Further, a source terminal of the NMOS transistor 426 and a drain terminal of the NMOS transistor 430 is coupled to VSS (e.g., ground terminal). The drain terminal of each of the PMOS transistors 420, 422, the source terminal of PMOS transistor 424, and the drain terminal of the NMOS transistor 574 are coupled to each other. Further, the circuit 504 is configured to receive operand B at the gate terminal of the NMOS transistor 574. Further, the drain terminal of PMOS transistor 424 and the drain terminals of the NMOS transistors 426 and 428 are coupled to provide output 466, e.g., A XOR B. The source terminal of NMOS transistor 428, the source terminal of NMOS transistor 430, and the source terminal of NMOS transistor 574 are coupled to each other. The output of the circuit 504 is A XOR B 466 and A NAND B 576.

The circuit 208 comprises a Boolean logic circuit for generating a negative carry output (CN) 270 for an input carry (CI). For example, the circuit 208 comprises a PMOS transistor 244 and an NMOS transistor 246. The gates of each of the PMOS transistor 244 and the NMOS transistor 246 are configured to receive the carry input (CI). A source terminal of the PMOS transistor 244 is coupled to a power terminal VDD. Further, a source terminal of the NMOS transistor 246 is coupled to VSS (e.g., ground terminal). The drain terminal of each of the PMOS transistor 244 and the NMOS transistor 246 are coupled to the output node 270, e.g., negative carry CN.

The circuit 406 comprises a Boolean logic circuit associated with an exclusive-OR gate. The circuit 406 comprises a bypass circuit including transistors 432 and 434, and a stack of transistors comprising transistors 436, 438, 440, and 442. The circuit 406 is configured to receive the negative carry input (CN) at the gate terminal of PMOS transistor 438 and at the gate terminal of NMOS transistor 434. Further, the circuit 406 is configured to receive the carry input (CI) as an input at the gate terminal of PMOS transistor 432 and at the gate terminal of NMOS transistor 440. Further, the circuit 406 is configured to receive the output A XOR B 466 of the circuit 504 as an input at the gate terminals of PMOS transistor 436 and NMOS transistor 442. The output of the circuit 406 is the sum output 268, e.g., A XOR B XOR Cl. A source terminal of the PMOS transistor 436 is coupled to a power terminal VDD. Further, a drain terminal of the NMOS transistor 442 is coupled to VSS (e.g., ground terminal). The drain terminal of the PMOS transistor 436 is coupled to the source terminal of the PMOS transistor 438. Further, the source terminal of the NMOS transistor 442 is coupled to the source terminal of NMOS transistor 440. Furthermore, the drain terminal of the PMOS transistor 438 and the drain terminal of the NMOS transistor 440 are coupled to the output of the bypass circuit comprising transistors 432 and 434 and the output sum generation S 268. Also, the source terminal of transistor 432 and the drain terminal of NMOS transistor 434 are coupled to output 466 (A NOR B) of the circuit 504, while the drain terminal of PMOS transistor 432 and the source terminal of NMOS transistor 434 are coupled to each other as well as with the output node of S 268. Thus, the generation of the output sum 268 is produced based on circuits 402, 504, and 406.

In some example embodiments, the carry output generation circuit 262 comprises a plurality of Boolean logic circuits including 402, 504, 208, and/or 410. The carry output generation circuit 262 is configured to receive one or more first operand inputs (A), one or more second operand inputs (B), one or more carry inputs (CI), and one or more inverse of carry (CN) inputs. The circuits 402, 504, and 208 are common with the sum generation circuit 260.

The circuit 410 comprises a Boolean logic circuit associated with an AND-OR-INVERT gate. The circuit 410 is configured to receive the inverse of carry (CN) as an input at the gate terminal of PMOS transistor 452. Further, the circuit 410 is configured to receive the output A NAND B 576 of the circuit 504 as an input at the gate terminal of PMOS transistor 450. Further, the circuit 410 is configured to receive the output A XOR B 466 of the circuit 504 as an input at the gate terminal of NMOS transistor 456. Furthermore, the circuit 410 is configured to receive the output A NOR B 464 of the circuit 402 as an input at the gate terminals of PMOS transistor 448 and NMOS transistor 454. Further, the circuit 410 is configured to receive the operand B as an input at the gate terminal of NMOS transistor 458. A source terminal of the PMOS transistor 448 is coupled to a power terminal VDD. Further, a source terminal of each of the NMOS transistors 454 and 458 is coupled to VSS (e.g., ground terminal). The drain terminal of each of the PMOS transistors 450, 452 and the drain terminal of each of the NMOS transistors 454, 456 are coupled to provide the output 272, e.g., carry output (CO). The drain terminal of PMOS transistor 448 is coupled to the source terminals of the PMOS transistors 450 and 452. Further, the drain terminal of NMOS transistor 458 and the source terminal of the NMOS transistor 456 are coupled to each other. The output of the circuit 410 is the carry output (CO) 272. Thus, the generation of the carry output (CO) 272 is produced based on circuits 402, 504, 208, and/or 410.

According to some example embodiments of the present disclosure, as shown in FIG. 5, the integrated circuit topology 500 is structured in order to limit a maximum number of NMOS and/or PMOS transistors, whereas the conventional full adder circuit as described in FIG. 1 has a 3-transistor stack. In particular, the number of stages and fan-out of the internal nodes of the circuit have been improved and/or optimized and hence help in reducing the overall delay of the circuit.

Also, the input pins A and B of the integrated circuitry topology 500 are each connected to no more than (e.g., exactly/only) 4 and 6 MOS transistors respectively, and input pin CI is connected to no more than (e.g., exactly/only) 4 MOS transistors, whereas the input pins A and B of the conventional full adder circuit as described in FIG. 1 are connected to 8 MOS transistors and the input pin CI of the conventional full adder circuit is connected to 6 MOS transistors. Further, the input pin CN is connected to no more than (e.g., exactly/only) 3 MOS transistors. Therefore, the integrated circuit topology 500 of the present inventive concepts helps in the reduction of the input capacitance for a preceding stage of the circuit. Moreover, the integrated circuit topology 500 of the present inventive concepts helps reduce the size (e.g., total area) of the full adder circuit. The maximum number of MOS transistors in the circuit topology is 25 compared to 28 MOS transistors in FIG. 1 of the background.

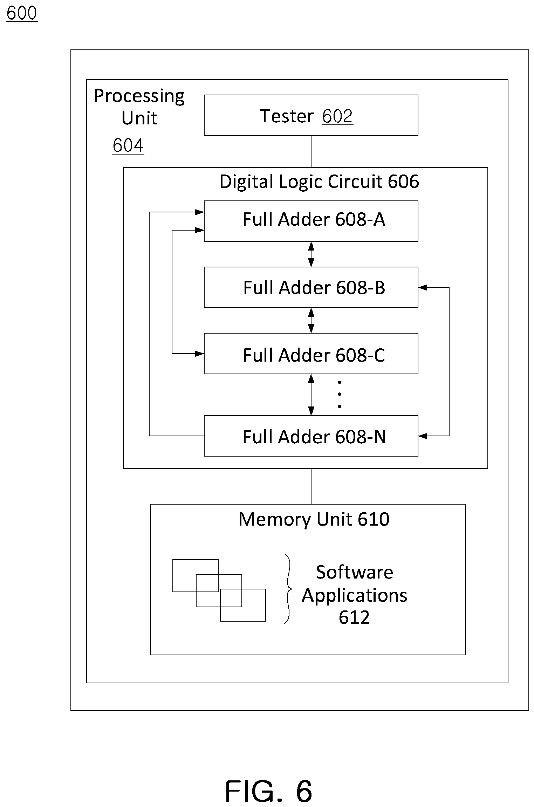

Referring now to FIG. 6, a computing system 600 is illustrated, in accordance with some example embodiments of the present inventive concepts. The integrated circuits 200, 300, 400, or 500 may be implemented in the computing system 600, according to some example embodiments of the present disclosure. The computing system 600 is, or is incorporated into but not limited to, a smartphone, a personal digital assistant, a personal computer, smartwatches, fitness trackers, a palmtop computer, a laptop computer, a desktop computer, a communications device, a wireless telephone, a land-line telephone, a web appliance, a network router, switch or bridge, or any other machine capable of executing a set of instructions (sequential or otherwise) that specify actions to be taken by that machine or any other type of electronic system. Further, while a single computing system 600 is illustrated, the term "system" shall also be taken to include any collection of systems or sub-systems that individually or jointly execute a set, or multiple sets, of instructions to perform one or more computer functions.

In some example embodiments, the computing system 600 comprises a tester 602, a mega cell, or a system-on-chip (SoC) which includes control logic such as a processing unit 604 (Central Processing Unit), a Digital Logic Circuit 606 including a plurality of full adders (608-A through 608-N), and/or a memory unit 610 (e.g., random access memory (RAM)).

The processing unit 604 can be, for example, a CISC-type (Complex Instruction Set Computer) CPU, a RISC-type CPU (Reduced Instruction Set Computer), a digital signal processor (DSP), or a graphics processing unit (GPU). The processing unit 604 may be a component in a variety of systems. For example, the processing unit 604 may be part of a standard personal computer or a workstation. The processing unit 604 may be one or more general processors, digital signal processors, application-specific integrated circuits, field-programmable gate arrays, servers, networks, digital circuits, analog circuits, combinations thereof, or other now known or later developed devices for analyzing and processing data. The processing unit 604 may implement a software program, such as code generated manually (e.g., programmed).

The memory unit 610 (which can be memory such as RAM, flash memory, or disk storage) stores one or more software applications 612 (e.g., embedded applications) that, when executed by the processing unit 604, perform any suitable function associated with the computing system 600. The memory unit 610 may include but is not limited to computer-readable storage media such as various types of volatile and non-volatile storage media, including but not limited to random access memory, read-only memory, programmable read-only memory, electrically programmable read-only memory, electrically erasable read-only memory, flash memory, magnetic tape or disk, optical media and the like.

The tester 602 comprises logic that supports testing and debugging of the computing system 600 executing the software applications 612. For example, the tester 602 can be used to emulate a defective or unavailable component(s) of the computing system 600 to allow verification of how the component(s), that was present on the computing system 600 and would perform in various situations (e.g., how the component(s) would interact with the software applications 612). In this way, the software application 612 can be debugged in an environment that resembles a post-production operation.

The Digital Logic Circuit 606 is used during the execution of the software application 612. At least one full adder of the plurality of full adders (608-A through 608-N) includes, or is similar to, the full adder circuitry shown in FIGS. 2, 3, 4, or 5 in connection and operation.

Further, in any of the above-mentioned example embodiments, the integrated circuits 200, 300, 400, or 500 of the present disclosure have lower average delay and/or relative delay at a cell level in comparison to the conventional full adder. Further, also at the block level, the data arrival time in case of any of the integrated circuits 200, 300, 400, or 500 is earlier/lower than that of the conventional full adder (see, for example, FIG. 1).

In the foregoing discussion, the term "connected" means at least either a direct electrical connection between the devices connected or an indirect connection through one or more passive intermediary devices. The term "circuit" means at least either a single component or a multiplicity of passive components, that are connected together to provide a desired function. Also, the terms "coupled to" or "couples with" (and the like) are intended to describe either an indirect or direct electrical connection. Thus, as an example, if an electronic device is coupled to another electronic device, that connection can be through a direct electrical connection, or through an indirect electrical connection via other devices and connections.

While specific language has been used to describe the disclosure, any limitations arising on account of the same are not intended. As would be apparent to a person in the art, various working modifications may be made to implement the inventive concepts as taught herein.

The drawings and the forgoing description give examples of example embodiments. Those skilled in the art will appreciate that one or more of the described elements may be combined into a single functional element. Alternatively, certain elements may be split into multiple functional elements. Elements from one example embodiment may be added to another example embodiment.

Also, those acts that are not dependent on other acts may be performed in parallel with the other acts. The scope of example embodiments is by no means limited by these specific examples. Numerous variations, whether explicitly given in the specification or not, such as differences in structure, dimension, and use of material, are possible. The scope of example embodiments is at least as broad as given by the following claims.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

Benefits, other advantages, and solutions to problems have been described above with regard to specific example embodiments. However, the benefits, advantages, solutions to problems, and any component(s) that may cause any benefit, advantage, or solution to occur or become more pronounced are not to be construed as a critical, required, or essential feature or component of any or all the claims.

## Claims

1. A Full Adder, FA, circuit, comprising:
a sum generation circuit configured to generate a sum output (S); and
a carry output generation circuit configured to generate a carry output (CO),
wherein each of the sum generation circuit and the carry output generation circuit is configured to receive a first operand input (A), a second operand input (B), and a carry input (CI),
wherein the sum generation circuit comprises a first exclusive-NOR gate and a second exclusive-NOR gate, wherein the second exclusive-NOR gate is configured to receive an output of the first exclusive-NOR gate to produce the sum output (S), and
wherein the carry output generation circuit comprises a first or-and-invert, OAI, gate, a second OAI gate, and a NAND gate,
wherein the first OAI gate is configured to receive an output of the NAND gate to generate one of an exclusive-NOR output or a NOR output of the first operand (A) and the second operand (B), and
wherein the second OAI gate is configured to receive the output of the NAND gate, an inverse of the carry input, and the generated one of the exclusive-NOR output or the NOR output to produce the carry output (CO).

2. The full adder circuit as claimed in claim 1 comprising:
a maximum of 4 metal-oxide semiconductor, MOS, transistors configured to receive the first operand input (A); and
a maximum of 5 MOS transistors configured to receive the second operand input (B).

3. The full adder circuit as claimed in claim 1 or 2, comprising a maximum of 25 MOS transistors.

4. The full adder circuit as claimed in claim 1, 2 or 3, wherein, when the first OAI gate is configured to generate the exclusive-NOR output, the first OAI gate comprises six MOS transistors.

5. The full adder circuit as claimed in claim 4, wherein the six MOS transistors comprise two MOS transistors configured to receive the first operand input (A) and two other MOS transistors configured to receive the second operand input (B).

6. The full adder circuit as claimed in claim 1, 2 or 3, wherein when the first OAI gate is configured to generate the NOR output, the first OAI gate comprises seven MOS transistors.

7. The full adder circuit as claimed in claim 6, wherein the seven MOS transistors comprise two MOS transistors configured to receive the first operand input and three other MOS transistors configured to receive the second operand input.

8. The full adder circuit as claimed in any preceding claim, wherein the second OAI gate comprises six MOS transistors.

9. The full adder circuit as claimed in claim 8, wherein the six MOS transistors of the second OAI gate comprise two MOS transistors configured to receive the output of the NAND gate, two other MOS transistors configured to receive the inverse of the carry input, and two remaining MOS transistors configured to receive the generated one of the exclusive-NOR output or the NOR output.

10. A Full Adder, FA, circuit, comprising:
a sum generation circuit configured to generate a sum output; and
a carry output generation circuit configured to generate a carry output,
wherein each of the sum generation circuit and the carry output generation circuit is configured to receive a first operand input, a second operand input, and a carry input,
wherein the sum generation circuit comprises a first exclusive-OR gate and a second exclusive-OR gate, wherein the second exclusive-OR gate is configured to receive an output of the first exclusive-OR gate to produce the sum output,
wherein the carry output generation circuit comprises a first and-or-invert, AOI, gate, a second AOI gate, and a NOR gate, and
wherein the carry output generation circuit is configured such that one of:
the first AOI gate is configured to receive an output of the NOR gate to generate one of an exclusive-OR output or a NAND output of the first operand and the second operand, and
the second AOI gate is configured to receive the output of the NOR gate, an inverse of the carry input, and the generated one of the exclusive-OR output or the NAND output to produce the carry output.

11. The full adder circuit as claimed in claim 10 comprising a maximum of 4 MOS transistors configured to receive the first operand input, and a maximum of 5 MOS transistors configured to receive the second operand input.

12. The full adder circuit as claimed in claim 10 or 11 comprising a maximum of 25 MOS transistors.

13. The full adder circuit as claimed in claim 10, 11 or 12, wherein when the first AOI gate is configured to generate the exclusive-OR output, the first AOI gate comprises six MOS transistors.

14. The full adder circuit as claimed in claim 13, wherein the six MOS transistors comprise two MOS transistors configured to receive the first operand input and two other MOS transistors configured to receive the second operand input.

15. The full adder circuit as claimed in claim 10, wherein when the first AOI gate is configured to generate the NAND output, the first AOI gate comprises seven MOS transistors.

## Amended claims

### Amended claims in accordance with Rule 137(2) EPC.

1. A Full Adder, FA, circuit, comprising:
a sum generation circuit configured to generate a sum output (S); and
a carry output generation circuit configured to generate a carry output (CO),
wherein each of the sum generation circuit and the carry output generation circuit is configured to receive a first operand input (A), a second operand input (B), and a carry input (CI),
wherein the sum generation circuit comprises a first exclusive-NOR gate and a second exclusive-NOR gate, wherein the second exclusive-NOR gate is configured to receive an output of the first exclusive-NOR gate to produce the sum output (S), and
wherein the carry output generation circuit comprises a first or-and-invert, OAI, gate, a second OAI gate, and a NAND gate,
wherein the first OAI gate is configured to receive an output of the NAND gate to generate a NOR output of the first operand (A) and the second operand (B), and
wherein the second OAI gate is configured to receive the output of the NAND gate, an inverse of the carry input, and the generated NOR output to produce the carry output (CO).

2. The full adder circuit as claimed in claim 1, comprising:
a maximum of 4 metal-oxide semiconductor, MOS, transistors configured to receive the first operand input (A); and
a maximum of 5 MOS transistors configured to receive the second operand input (B).

3. The full adder circuit as claimed in claim 1 or 2, comprising a maximum of 25 MOS transistors.

4. The full adder circuit as claimed in claim 1, 2 or 3, wherein the first OAI gate comprises seven MOS transistors.

5. The full adder circuit as claimed in claim 4, wherein the seven MOS transistors comprise two MOS transistors configured to receive the first operand input and three other MOS transistors configured to receive the second operand input.

6. The full adder circuit as claimed in any preceding claim, wherein the second OAI gate comprises six MOS transistors.

7. The full adder circuit as claimed in claim 6, wherein the six MOS transistors of the second OAI gate comprise two MOS transistors configured to receive the output of the NAND gate, two other MOS transistors configured to receive the inverse of the carry input, and two remaining MOS transistors configured to receive the generated one of the exclusive-NOR output or the NOR output.

8. A Full Adder, FA, circuit, comprising:
a sum generation circuit configured to generate a sum output; and
a carry output generation circuit configured to generate a carry output,
wherein each of the sum generation circuit and the carry output generation circuit is configured to receive a first operand input, a second operand input, and a carry input,
wherein the sum generation circuit comprises a first exclusive-OR gate and a second exclusive-OR gate, wherein the second exclusive-OR gate is configured to receive an output of the first exclusive-OR gate to produce the sum output,
wherein the carry output generation circuit comprises a first and-or-invert, AOI, gate, a second AOI gate, and a NOR gate, and
wherein the carry output generation circuit is configured such that one of:
the first AOI gate is configured to receive an output of the NOR gate to generate one of an exclusive-OR output or a NAND output of the first operand and the second operand, and
the second AOI gate is configured to receive the output of the NOR gate, an inverse of the carry input, and the generated one of the exclusive-OR output or the NAND output to produce the carry output.

9. The full adder circuit as claimed in claim 8, comprising a maximum of 4 MOS transistors configured to receive the first operand input, and a maximum of 5 MOS transistors configured to receive the second operand input.

10. The full adder circuit as claimed in claim 8 or 9, comprising a maximum of 25 MOS transistors.

11. The full adder circuit as claimed in claim 8, 9 or 10, wherein when the first AOI gate is configured to generate the exclusive-OR output, the first AOI gate comprises six MOS transistors.

12. The full adder circuit as claimed in claim 11, wherein the six MOS transistors comprise two MOS transistors configured to receive the first operand input and two other MOS transistors configured to receive the second operand input.

13. The full adder circuit as claimed in claim 8, wherein when the first AOI gate is configured to generate the NAND output, the first AOI gate comprises seven MOS transistors.
